# EUROPEAN PATENT APPLICATION

(11) **EP 1 505 647 A2**
(43) Date of publication of application: **09.02.2005**
(21) Application number: 04018762.7
(22) Date of filing: 06.08.2004
(51) Int. Cl.: H01L 27/00

(54) **Organic EL device, method of manufacturing the same and electronic apparatus**

(30) Priority: 08.08.2003 JP 2003290654
(71) Applicant: Seiko Epson Corporation, Shinjuku-ku, Tokyo 163-0811 (JP)
(72) Inventor: Uchida, Masahiro, Suwa-shi Nagano-ken 392-8502 (JP); Seki, Shunichi, Suwa-shi Nagano-ken 392-8502 (JP)
(74) Representative: HOFFMANN - EITLE

(57) **Abstract**

[Object] To provide a organic EL device capable of obtaining optimal light-emitting characteristics for individual organic EL elements and improving display characteristics, a method of manufacturing the organic EL device, and an electronic apparatus.

[Solving Means] An organic EL device 1 comprises a plurality of organic EL elements, each of which has a pair of electrodes 111 and 12 and functional layers 110 including at least a hole injection layer 151 and a light-emitting layer 150 between the electrodes. A property improving layer 153 for improving the light-emitting characteristics is provided between a hole injection layer and a light-emitting layer of one organic EL element among the organic EL elements. With respect to the hole injection layers 151 and the light-emitting layers 150 in the functional layers of other organic EL elements, the structure of the hole injection layers 151 and the functional layers 110 in one organic EL element among the organic EL elements is different from components other than the at least the hole injection layers 151 and the light-emitting layers 150 in other organic EL elements.

## Description

### [Technical Field]

The present invention relates to an organic EL device capable of improving characteristics of individual organic EL elements and display characteristics, a method of manufacturing the same, and an electronic apparatus.

### [Background Art]

Recently, organic electroluminescent elements (hereinafter, referred to as organic EL elements) using organic materials functioning as light-emitting layers have been developed as self-emitting display devices. In an organic EL device having a plurality of the organic EL elements, functional materials for forming functional layers such as light-emitting layers and carrier injection/transport layers, that is, hole injection/transport layers or electron injection/transport layers, has become one of the important factors which affects the characteristics of a completed organic EL device.

Particularly, in such an organic EL device in which materials for forming the light-emitting layers are polymers, the functional layers typically comprise light-emitting layers and hole injection/transport layers (for example, see Patent Documents 1 and 2). In an organic EL device, which is capable of displaying full colors, the organic EL elements comprise organic EL elements for emitting a red light component, organic EL elements for emitting a green light component, and organic EL elements for emitting a blue light component. Among the organic EL elements emitting different colors of light components, the light-emitting layers for every color are respectively composed of different materials, but the other functional layers have the same material to improve the productivity.

In addition, a technique for changing the construction of components other than functional layers, particularly, construction of cathodes by changing colors is disclosed. More specifically, a technique for forming cathodes by providing LiF to light-emitting layers of only the organic EL elements for emitting a blue light component is disclosed.
[Patent Document 1] Japanese Unexamined Patent Application Publication No. 2000-323276
[Patent Document 2] Japanese Unexamined Patent Application Publication No. 2002-231447

### [Disclosure of the Invention]

### [Problems to be Solved by the Invention]

However, in the aforementioned organic EL device, particularly, an organic EL device for displaying full colors, since the light-emitting layers are composed of different materials for every color, optimal light-emitting characteristics cannot be obtained. But, in this case, the hole injection/transport layers are formed commonly to the light-emitting layers composed of the different materials, and the electron injection/transport layers are not provided for all the colors. Therefore, organic EL elements having optimal light-emitting conditions cannot be formed.
Recently, improvements in the display characteristics of the organic EL devices have been desired. Hence, it is important to provide the individual organic EL elements having optimal light-emitting characteristics.

In order to solve the problems, the present invention provides an organic EL device capable of improving the characteristics of individual organic EL elements and display characteristics, a method of manufacturing the organic EL device, and an electronic apparatus.

### [Means for Solving the Problems]

In order to achieve the objects, the present invention provides an organic EL device comprising a plurality of organic EL elements, in which each includes a pair of electrodes and a functional layer between the electrodes, and the functional layer includes a hole injection layer and a light-emitting layer. One of the organic EL element has a property improving layer between the hole injection layer and the light-emitting layer, and another of the organic EL element does not have a property improving layer between the hole injection layer and the light-emitting layer.
According to the above structure, in order to improve the characteristics of some of the organic EL elements, it is possible to improve the characteristics by providing the property improving layer only in the object element.

In addition, the organic EL device according to the present invention comprises a plurality of organic EL elements, in which each includes a pair of electrodes and a functional layer between the electrodes, the functional layer includes a hole injection layer and a light-emitting layer, a first property improving layer is provided between a hole injection layer and a light-emitting layer of one organic EL element among the organic EL elements, and a second property improving layer is provided between a hole injection layer and a light-emitting layer of the other organic EL element, the second property improving layer has a different material from the first property improving layer.
According to the above structure, since the first improving layer is provided between a hole injection layer and a light-emitting layer of one organic EL element, the light-emitting characteristics of the organic EL element is improved. Further, the structure of the hole injection layer and the light-emitting layer in the organic EL element is different from components other than at least the hole injection layers and the light-emitting layers of other organic EL elements. For example, since the second property improving layer that has a different material from the first property improving layer is provided between a hole injection layer and a light-emitting layer in the other organic EL element, it is possible to improve the characteristics according to the hole injection layer and the light-emitting layer in the other organic EL element. As a result, better light-emitting characteristics can be obtained.

In addition, in the organic EL device, a color emitted from a light-emitting layer of the one organic EL element is different from colors emitted from light-emitting layers of the other organic EL elements.
According to the above structure, it is possible to obtain better light-emitting characteristics for the organic EL elements for emitting different light components.

In addition, in the organic EL device, the other organic EL elements may have a property improving layer, which is different from the one organic EL element, between the hole injection layer and the light-emitting layer.
According to the above structure, the characteristics of both the one organic EL element and the other organic EL elements can be improved according to the hole injection layer and the light-emitting layer, and consequently it is possible to eventually improve the characteristics of all organic EL elements. Therefore, better light-emitting characteristics for all organic EL elements can be obtained.

It is preferable that the thickness of the property improving layers is 1 to 10 nm in the organic EL element.
If the thickness of the property improving layer exceeds 10 nm, resistance becomes high to cause insulation. Further, it is difficult to form uniformly the property improving layer having below 1 nm, thus, 1 nm or more is preferable.

In addition, the LUMO level of a material for forming the property improving layers is preferably nearer to the vacuum level than the LUMO level of a material for forming the light-emitting layer in the same organic EL element.
According to the above structure, it is possible to prevent the electrons remained on the light-emitting layer from moving to the hole injection layer due to altered the carrier balance.

In addition, the HOMO level of the material for forming the property improving layer is preferably between the HOMO level of the material for forming the light-emitting layers and the HOMO level of the material for forming the hole injection layer, in the organic EL element.
According to the above structure, a hole transporting layer from the hole injection layer to the light-emitting layer becomes thicker by the property improving layer.

The organic EL device according to the present invention further comprises organic EL elements for emitting a red light component, organic EL elements for emitting a green light component, and organic EL elements for emitting a blue light component.
According to the above structure, it is possible to perform full color display.

A method of manufacturing an organic EL device that comprises a plurality of organic EL elements, each including a pair of electrodes and a functional layer between the electrodes, the functional layer including a hole injection layer and a light-emitting layer, comprises the step of forming a property improving layer between the hole injection layer and the light-emitting layer of one organic EL element among the organic EL elements, and forming a property improving layer between the hole injection layer and the light-emitting layer of another organic EL element.
In addition, as a method of manufacturing an organic EL device that comprises a plurality of organic EL elements, each including a pair of electrodes and a functional layer between the electrodes, the functional layer including a hole injection layer and a light-emitting layer, the method comprises the step of forming a first property improving layer between the hole injection layer and the light-emitting layer of one organic EL element among the organic EL elements, and forming a second property improving layer between the hole injection layer and the light-emitting layer of another organic EL element.
According to the above method of manufacturing the organic EL device, since the first improving layer is provided between a hole injection layer and a light-emitting layer of one organic EL element, the light-emitting characteristics of the organic EL element is improved. Further, the structure of the hole injection layer to the light-emitting layer in the organic EL element is different from components other than at least the hole injection layers and the light-emitting layers of other organic EL elements. For example, since the second property improving layer that has a different material from the first property improving layer is provided between a hole injection layer and a light-emitting layer in the other organic EL element, it is possible to improve the characteristics according to the hole injection layer and the light-emitting layer in the other organic EL element. As a result, better light-emitting characteristics can be obtained.

In addition, in the method of manufacturing the organic EL device, the functional layers may be formed by applying a liquid material containing a material for forming the functional layers using a liquid droplet ejection method.
As a result, a desired amount of the liquid material can be accurately applied on the desired locations with the liquid droplet ejection method, so that it is possible to easily adjust the constructions of the functional layers for individual organic EL elements.

In the above method of manufacturing the organic EL device, the property improving layer is formed by insolubilizing process after applying the liquid material containing the material for forming the property improving layer by using the liquid droplet ejecting method.
According to the above method, when the light-emitting layer is formed on the property improving layer, the property improving layer is not re-dissolved by a solvent in the liquid material for forming the light-emitting layer. Therefore, it is possible to stably form the property improving layer between the hole injection layer and the light-emitting layer.

The present invention also provides an electronic apparatus comprising the aforementioned organic EL device or an organic EL device manufactured by using the aforementioned method.
According to the electronic apparatus, the organic EL device having better light-emitting characteristics for the individual organic EL elements is included as a display unit, so that it is possible to obtain better display characteristics.

### [Brief Description of the Drawings]

Fig. 1 is a schematic plan view showing a wiring structure of an organic EL device according to an embodiment of the present invention.
Fig. 2(a) is a plan view showing an organic EL device, and Fig. 2(b) is a sectional view taken along line AB of Fig. 2(a).
Fig. 3 is a sectional side view showing a main portion of the organic EL device shown in Figs. 1 and 2.
Fig. 4 is a sectional side view for explaining a main portion of a method of manufacturing the organic EL device shown in Fig. 3.
Fig. 5 is a sectional side view for explaining a method of manufacturing the organic EL device shown in Fig. 3.
Figs. 6(a) and 6(b) illustrate internal structures of a liquid droplet ejection head of a liquid droplet ejection device.
Fig. 7 is a sectional view for explaining a method of manufacturing the organic EL device shown in Fig. 3.
Fig. 8 is a sectional view for explaining a method of manufacturing the organic EL device shown in Fig. 3.
Fig. 9 is a sectional view for explaining a method of manufacturing the organic EL device shown in Fig. 3.
Fig. 10 is a sectional view for explaining a method of manufacturing the organic EL device shown in Fig. 3.
FIG. 11 is a perspective view showing an electronic apparatus according to the present invention.

### [BEST MODE FOR CARRYING OUT THE INVENTION]

Now, the present invention will be described in detail.

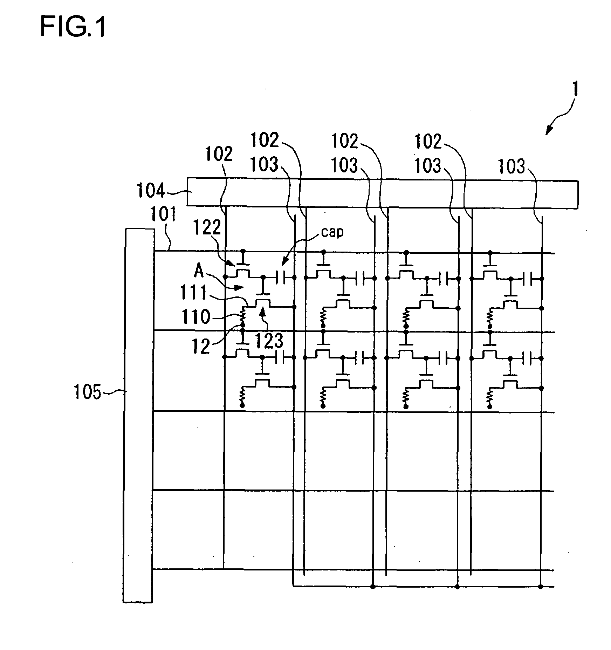

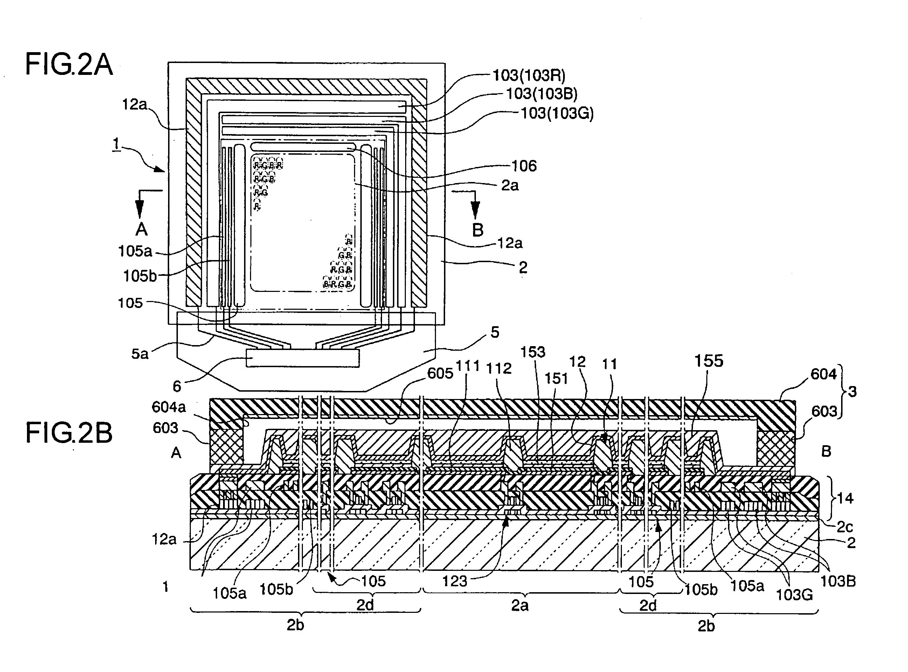

Figs. 1 and 2 illustrate an active matrix display apparatus for full color display to which an organic EL device according to an embodiment of the present invention is applied. In the figures, reference numeral 1 denotes the organic EL device.

Fig. 1 is a schematic plan view showing a wiring structure of the organic EL device 1 according to the embodiment. Fig. 2 illustrates a schematic plan view and a schematic sectional view showing the organic EL device 1 according to the embodiment.
As shown in Fig. 1, the organic EL device 1 comprises wiring lines including a plurality of scan lines 101, a plurality of signal lines 102 intersecting the scan lines 101, and a plurality of power lines 103 extending parallel to the signal lines 102, and pixel regions A are formed at intersections of the scan lines 101 and the signal lines 102.

A data driving circuit 104 comprising a shift register, a level shifter, a video line, and an analog switch is connected to the signal lines 102. In addition, a scan driving circuit 105 comprising shift registers and level shifters is connected to the scan lines 101.
In each of the pixel regions A, a first thin film transistor 122 having a gate electrode to which a scan signal is provided via one of the scan lines 101, a storage capacitor cap for storing a pixel signal provided from one of the signal lines 102 via the first thin film transistor 122, a second thin film transistor 123 having a gate electrode to which the pixel signal stored in the storage capacitor cap is provided, a pixel electrode (anode) 111 to which a driving current flows from one of the power lines 103 when the pixel electrode (anode) 111 is connected to the power line 103 via the second thin film transistor 123, and the light-emitting portion 110 which is interposed between the pixel electrode (anode) 111 and a counter electrode (cathode) 12 are provided. The pixel electrode 111, the counter electrode 12, and the light-emitting portion 110 constitute the organic EL element in the present invention.

According to the above construction, when the first thin film transistor 122 turns on by driving the scan line 101, a potential of the signal line 102 is stored in the storage capacitor cap, and the on/off state of the second thin film transistor 123 is determined based on the state of the storage capacitor cap. Next, current flows from the power line 103 to the pixel electrode 111 via a channel of the second thin film transistor 123, and the current flows into the cathode 12 via the light-emitting portion 110. The light-emitting portion 110 emits light based on an amount of the current thereof.

As shown in Figs. 2(a) and 2(b), the organic EL device 1 according to the present embodiment comprises a substrate 2 made of a light-transmitting material such as glass, a plurality of organic EL elements arranged in a matrix on the substrate 2, and a sealing substrate for sealing the organic EL elements. Each of the organic EL elements disposed on the substrate 2 comprises the pixel electrode 111, the light-emitting portion 110, and the cathode 12 as described above.
The substrate 2 is a transparent (light-emitting) material such as glass. A display region 2a is provided in the central region of the substrate 2, and a non-display region 2b is provided along the periphery of the substrate 2, that is, outside the display region 2a.
The display region 2a is an effective display region, which is constructed by the organic EL elements arranged in the matrix. In addition, a dummy display region 2d is provided adjacent to the display region 2a in the non-display region 2b.

As shown in Fig. 2(b), a circuit element portion 14 is provided between the substrate 2 and an EL element portion 11 comprising the organic EL elements and bank portions. The aforementioned scan lines, the signal lines, the storage capacitors, the first thin film transistors, and the second thin film transistors 123 are formed in the circuit element portion 14.
The cathodes 12 are connected to the cathode wiring lines 12a whose ends are formed on the substrate 2, and ends of the cathode wiring lines are connected to wiring lines 5a formed on a flexible substrate 5. The wiring lines 5a are connected to a driving IC 6 (a driving circuit) formed on the flexible substrate 5.

As shown in Figs. 2(a) and 2(b), the aforementioned power lines 103 (103R, 103G, 103B) are disposed in the non-display region 2b of the circuit element portion 14.
The scan driving circuits 105 are disposed at both sides of the display region 2a of Fig. 2(a). The scan driving circuits 105 are provided in the circuit element portion 14 below the dummy region 2d. In addition, driving circuit control signal wiring lines 105a and power wiring lines 105b for driving circuit which are connected to the scan line driving circuits 105 are disposed in the circuit element portion 14.
An inspection circuit 106 is disposed at an upper side of the display region 2a of Fig. 2(a). The quality and defects of the display apparatus are inspected with the inspection circuit 106 during production or at the time of shipment.

As shown in Fig. 2(b), a sealing portion 3 is provided on the EL element portion 11. The sealing portion 3 comprises a sealing resin 603 applied on the substrate 2 and a sealing substrate 604. The sealing resin 603 is a thermosetting resin or a UV-cured resin, and more preferably, an epoxy resin.
The sealing resin 603 is applied in a ring shape around the periphery of the substrate 2 by using, for example, a micro-dispenser to adhere the sealing substrate 604 to the substrate 2. According to the construction, the sealing resin 603 prevents water or oxygen from penetrating into the space between the substrate 2 and the sealing substrate 604, and the light-emitting layers (not shown) formed within the cathodes 12 or the EL element portion 11 from being oxidized.
Since the sealing substrate 604 is made of glass or metal. The sealing substrate is adhered to the substrate with the sealing resin 603, and concave portions 604a are formed inside thereof. A getter 605 capable of absorbing water and oxygen is attached on the concave portion 604a to absorb the water or oxygen that penetrates the sealing substrate 604.

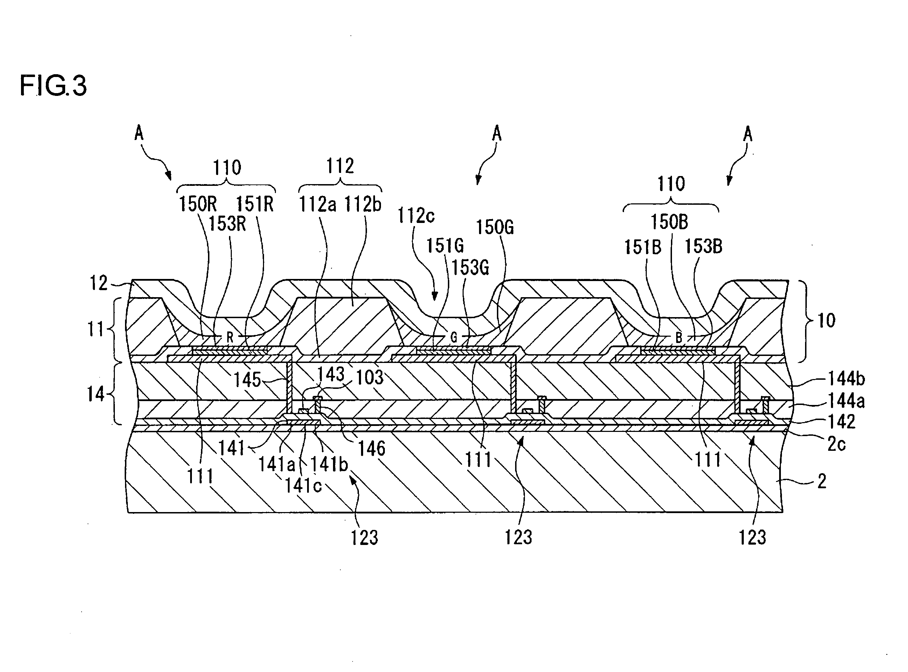

Fig. 3 illustrates an enlarged sectional side view of the display region of the organic EL device 1. Fig. 3 illustrates three pixel regions A. In the organic EL device 1, the circuit element portion 14, where circuits such as TFTs are formed, and the EL element portion 11, where the light-emitting portions 110 are formed, are laminated in this order on the substrate 2.
In the organic EL device 1, light emitted from the light-emitting portion 110 toward the substrate 2 transmits through the circuit element portion 14 and the substrate 2 and is emitted to the rear side of the substrate 2 (toward an observer). On the other hand, light emitted from the light-emitting portion 110 toward the opposite side of the substrate 2 is reflected by the cathode 12, transmits through the circuit element portion 14 and the substrate 2, and is emitted to the rear side of the substrate 2 (toward the observer).
Alternatively, if a transparent material is used for the cathode 12, light can be emitted from the cathode 12.

In the circuit element portion 14, a base protection film 2c made of a silicon oxide film is provided on the substrate 2. Semiconductor films 141 made of polycrystalline silicon are provided in an island shape on the base protection film 2c. In each of the semiconductor films 141, a source region 141a and a drain region 141b are formed by injecting heavily-doped P ions. A region where the P ions are not injected becomes a channel region 14c.
In the circuit element portion 14, a transparent gate insulating film 142 is provided to cover the base protection film 2c and the semiconductor films 141. Gate electrodes 143 (the scan lines 101) made of Al, Mo, Ta, Ti, W, or the like, are provided on the gate insulating film 142. First and second transparent interlayer insulating films 144a and 144b are provided on the gate electrodes 143 and the gate insulating film 142. The gate electrodes 143 are provided at positions corresponding to the channel regions 141c of the semiconductor films 141.

Contact holes 145 and 146 are formed through the first and second interlayer insulating films 144a and 144b and are connected to the source and drain regions 141a and 141b of the semiconductor films 141, respectively. The contact holes 145 and 146 are filled with conductive materials.
The transparent pixel electrodes 111 made of ITO are patterned in a predetermined shape on the second interlayer insulating film 144b. The contact holes 145 are connected to the pixel electrodes 111.
In addition, the contact holes 146 are connected to the power lines 103.
As a result, the second thin film transistors 123 connected to the pixel electrodes 111 are formed in the circuit element portion 14.
In addition, although the aforementioned storage capacitors cap and the first thin film transistors 122 are also provided in the circuit element portion 14, they are omitted in Fig. 3.

The EL element portion 11 comprises the light-emitting portions 110 laminated on the plurality of the pixel electrodes 111, the bank portion provided between the pixel electrodes 111 and the light-emitting portions 110 to partition the light-emitting portions 110, and the counter electrodes (cathodes 12) provided on the bank portions 112 and the light-emitting portions 110.
Since the pixel electrodes 111 are made of a transparent conductive material such as ITO, the pixel electrodes 111 are patterned in a rectangular shape in plan view. The bank portions 112 are provided between the pixel electrodes 111.

The bank portions 112 comprise an inorganic bank layer 112a made of SiO₂ over the substrate 2 and an organic bank layer 112b formed on the inorganic bank layer 112a.
Since the inorganic bank layers 112a are formed over the circumferential portions of the pixel electrodes 111, the circumferential portions of the pixel electrodes 111 and the inorganic bank layers 112a are overlapped in plan view. In addition, some portions of the pixel electrodes 111 and the organic bank layers 112b are also overlapped in plan view.
Openings 112c are formed in the organic bank layers 112b. As described later, materials for forming the functional layers are disposed in the openings 112c and subjected to a film formation process, so that the light-emitting portions 110 constituting the functional layers are formed. In addition, the organic bank layers 112b are made of a material having heat resistance and solvent resistance such as acryl resin and polyimide resin.

As described above, the light-emitting portions 110 functioning as the functional layers in the present invention are provided between the pixel electrodes (anodes) 111 and the counter electrodes (cathodes) 12, so that the light-emitting portions together with the pixel electrodes 111 and the counter electrodes 12 constitutes the organic EL elements. In the embodiment, as described above, the organic EL elements include the organic EL elements serving as the pixels R emitting a red color component, the organic EL elements serving as the pixels G emitting a green color component, and the organic EL elements serving as the pixels B emitting a blue color component in order to display full colors.

In the present embodiment, each of the three organic EL elements comprises first, second, and third property improving layers 153 (153R, 153G, 153B) provided between the hole injection layers 151 (151R, 151G, 151B) and the light-emitting layers 150 (150R, 150G, 150B) as the light-emitting portions (functional layers) 110.
The hole injection layers 151 have a function of injecting holes of the pixel electrode (anodes) 111 into the light-emitting layers 150 or transporting the holes therein. Since the hole injection layers are provided between the pixel electrodes 111 and the light-emitting layers 150, it is possible to improve the light-light-emitting characteristics and the life time of the light-emitting layers 150. In addition, in the light-emitting layers 150, the holes injected from the hole injection layers 151 and the electrons injected from the counter electrodes (cathodes) 12 are recombined to emit light.

According to the present embodiment, the hole injection layers 151 (151R, 151G, 151B) of the organic EL elements are made of a mixture of 3, 4- polyethylenedioxytiophene (PEDOT) and polystyrene sulfonic acid (PSS). Specifically, the mixture of PEDOT and PSS may be dispersed in a dispersion medium having water as a main component to become a liquid material for forming the hole injection layers 151. As described later, the liquid material is applied in the openings 112c by the liquid droplet ejection method to form films having a thickness of 50 nm, and thus the hole injection layers 151 (151R, 151G, 151B) are formed.

CN-PPV (hereinafter, referred to as "Compound 1") can be very suitably used as a material for forming the light-emitting layers 150R of the organic EL element for emitting a red light component among the light-emitting layers 150 of the organic EL element. The compound 1 is dissolved into a solvent such as xylene or trimethylbenzene to constitute a liquid material for forming the light-emitting layers 150R. Next, as described later, the liquid material is applied in the openings 112c by liquid droplet ejection method to form films having a thickness of about 80 nm, so that the light-emitting layers 150R are formed.

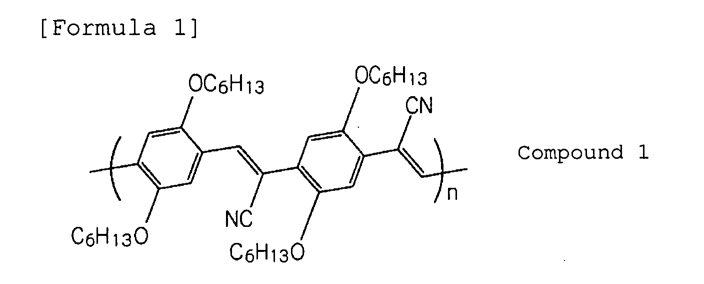

A mixture of 1:1 of F8BT (hereinafter, referred to as "Compound 2") and TFB (hereinafter, referred to as "Compound 3") is very suitably used as a material for forming the light-emitting layers 150G of the green organic EL elements. The mixture of Compounds 2 and 3 is dissolved into the solvent such as xylene or trimethylbenzene to constitute a liquid material for forming the light-emitting layers 150G. Therefore, as described later, the liquid material is applied in the openings 112c by the droplet ejection method to form films having a thickness of about 80 nm, such that the light-emitting layers 150G are formed.

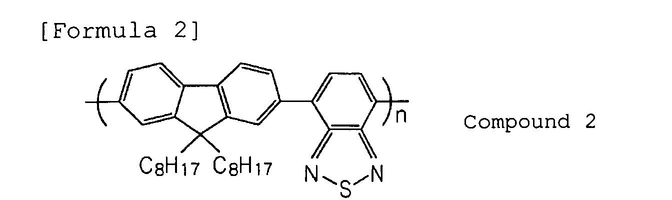

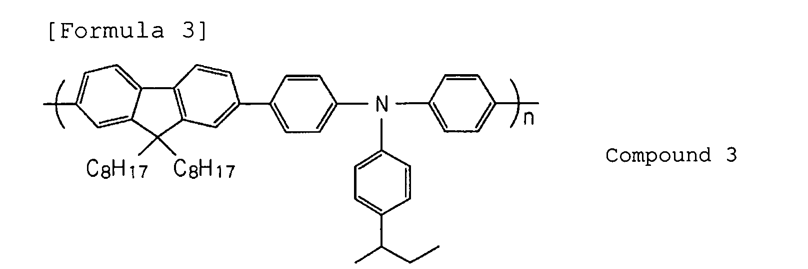

F8 (poly-dioctylfluorene) (hereinafter, referred to as "Compound 4") can be very suitably used as a material for forming the light-emitting layers 150B of the blue light organic EL elements. Compound 4 is dissolved into the solvent such as xylene or trimethylbenzene to constitute a liquid material for forming the light-emitting layers 150B. Therefore, as described later, the liquid material is applied in the openings 112c by the liquid droplet ejection method to form films having a thickness of about 70 nm, such that the light-emitting layers 150B are formed.

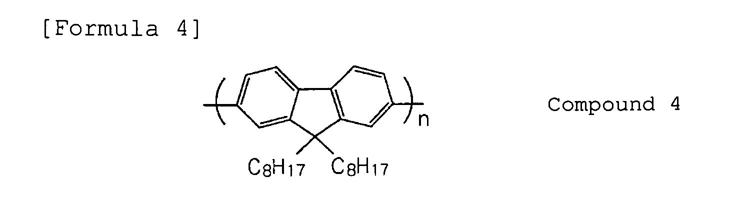

In this embodiment, the first, second, and third property improving layers 153 (153R, 153G, 153B), which are arranged between the hole injection layers 151 (151R, 151G, 151B) and the light-emitting layers 150 (150R, 150G, 150B), are formed of different materials for every color organic EL element. That is, the property improving layer 153R for organic EL element for emitting a red light component is made of poly[9,9-dioctylfluorenyl-2,7-diyl]-co-(1,4-ethylenylbenzene)] which is represented by Compound 5.
Further, the property improving layer 153G for organic EL element for emitting a green light component is made of poly[9,9-dihexylfluorenyl-2,7-diyl]-co-(9,-ethyl-3,6-carvazole)] which is represented by Compound 6.
The property improving layer 153B for organic EL element for emitting a blue light component is made of poly[9,9-dihexylfluorenyl-2,7-diyl]-co-(2,5-p-xylene)] which is represented by Compound 7.
Each of the compounds is dissolved into a nonpolar solvent to constitute a liquid material for forming the property improving layers 153. Therefore, as described later, the liquid material is applied on the hole injection layers 151 in the openings 112c by the liquid droplet ejection method to form films so that the property improving layers 153 are formed.

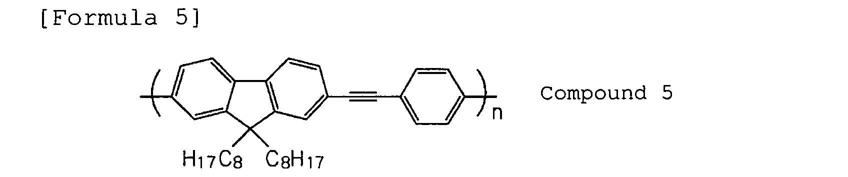

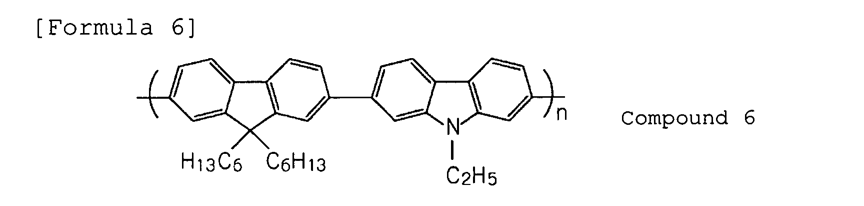

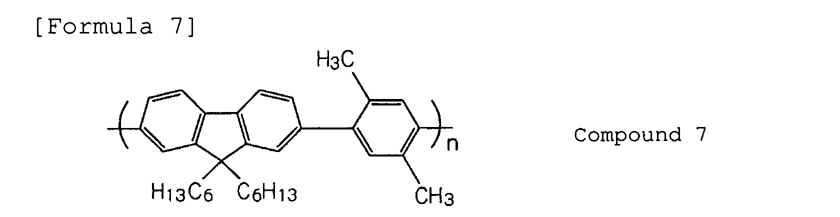

Each of the property improving layers 153R, 153G, 153B made of the above materials is formed between the hole injection layers 151R, 151G, 151B and the light-emitting layers 150R, 150G, 150B having a thickness of about 1 to 10 nm, preferably about 5 nm such that the property improving layers show the below functions:
(1) When electrons from a cathode (counter electrode) 12 or holes from an anode (pixel electrode) 111 are supplied to the light-emitting layers 150, the balance between the supplied electrons or holes is altered due to unknown cause, the electrons remained on the light-emitting layers 150 is prevented from moving to the hole injection layer 151. As a result, it is possible to improve the light-emitting characteristics.
(2) An exciter composed of electrons and holes, which are recoupled in the light-emitting layers 150, is prevented from diffusing into the hole injection layer 151. Therefore, it is possible to improve the light-emitting characteristics.
(3) Ionic impurity from the hole injection layers 151 is prevented from diffusing into the light-emitting layers 150. Thus, it is possible to prevent from shortening the lifetime due to the ionic impurity. (4) Further, transport of hole from the hole injection layer 151 to the light-emitting layer 150 is improved. As a result, it is possible to improve the light-emitting characteristics.

In order to satisfactorily show the function (1), it is preferable to use as a material for the property improving layer 153 one whose LUMO level is nearer the vacuum level than that of the material for forming the light-emitting layers 150 in the same organic EL element.
Further, in order to satisfactorily show the function (1), it is preferable to use below compounds as a material for the property improving layer 153.

[4-(2,2-diphenylvinyl)phenyl][4-(diphenylamino)phenyl]phenylamine, [4-(2,2-diphenylvinyl)phenyl](4-methoxyphenyl){4-[(4-methoxyphenyl)phenylamino]phenyl}amine, bis[4-(2,2-diphenylvinyl)phenyl][4-(diphenylamino)phenyl]amine, bis[4-(2,2-diphenylvinyl)phenyl][4-{bis(methoxyphenyl)amino}phenyl]amine, [4-(4,4-diphenylbuta-1,3-dienyl)phenyl][4-(diphenylamino)phenyl]phenylamine, [4-(4,4-diphenylebuta-1,3-diphenyl)phenyl][4-{bis(4-methoxyphenyl)amino}phenyl](4-methoxyphenyl)amine, bis[4-(4,4-diphenylbuta-1,3-dienyl)phenyl][4-(diphenylamino)phenyl]amine, bis[4-(4,4-diphenylbuta-1,3-dienyl)phenyl][4-{bis(4-methoxyphenyl)amino}phenyl]amine, [4-{2-azo-2-(diphenylamino)vinyl}phenyl][4-(diphebnylamino)phenyl]phenylamine, [4-{2-azo-2-(diphenylamino)vinyl}phenyl][4-{bis(4-methoxyphenyl)amino}phenyl](4-methoxyphenyl)amine, bis[4-{2-azo-2-(diphenylamino)vinyl}phenyl][4-(diphenylamino)phenyl]amine, bis[4-{2-azo-2-(diphenylamino)vinyl}phenyl][4-{bis(4-methoxyphenyl)amino}phenyl]amine, [4-{4-(2,2-diphenylvinyl)phenyl}phenyl]diphenylamine, [4-{4-(2,2-diphenylvinyl)phenyl}phenyl]bis(4-methoxyphenyl)amine, bis[4-{4-(2,2-diphenylvinyl)phenyl}phenyl]phenylamine, bis[4-{4-(2,2-diphenylvinyl)phenyl}phenyl](4-methoxyphenyl)amine, tris[4-{4-(2,2-diphenylvinyl)phenyl}phenyl]amine, tris[4-{4-(2,2-diphenylvinyl)-2-methylphenyl}-3-methylphenyl]amine, [4-{4-(4,4-diphenylbuta-1,3-dienyl)phenyl}phenyl]diphenylamine, [4-{4-(4,4-diphenylbuta-1,3-dienyl)phenyl}phenyl]bis(4-methoxyphenyl)amine, bis[4-{4-(4,4-diphenylbuta-1,3-dienyl)phenyl}phenyl]diphenylamine, bis[4-{4-(4,4-diphenylbuta-1,3-dienyl)phenyl}phenyl]phenylamine, bis[4-{4-(4,4-diphenylbuta-1,3-dienyl)phenyl}phenyl](4-methoxyphenyl)amine, tris[4-{4-(4,4-diphenylbuta-1,3-dienyl)phenyl}phenyl]amine, tris[4-{4-(4,4-diphenylbuta-1,3-dienyl)-2-methylphenyl}-3-methylphenyl]amine, [4-{4-{2-azo-2-(diphenylamino)vinyl}phenyl}phenyl]diphenylamine, [4-{4-{2-azo-2-(diphenylamino)vinyl}phenyl}phenyl]bis(4-methoxyphenyl)amine, bis[4-{4-{2-azo-2-(diphenylamino)vinyl}phenyl}phenyl]phenylamine, bis[4-{4-{2-azo-2-(diphenylamino)vinyl}phenyl}phenyl](4-methoxyphenyl)amine, tris[4-{4-(2-azo-2-(diphenylamino)vinyl)phenyl}phenyl]amine, tris[4-{4-{2-azo-2-(diphenylamino)vinyl}-2-methylphenyl}-3-methylphenyl]amine, bis[4-{bis(3-methylphenyl)amino}phenyl](4-phenylphenyl)amine, bis[4-{bis(4-methoxyphenyl)amino}phenyl](4-phenylphenyl)amine, bis[4-(diphenylamino)phenyl](4-methylphenyl)amine, bis[4-(diphenylamino)phenyl]{4-(4-methoxyphenyl)phenyl}amine, bis[4-(diphenylamino)phenyl][4-{4-(4-phenyl)phenyl}phenyl]amine.

Among the compounds, the optimum compound is selected for every color of the organic EL element according to the material for forming the light-emitting layers 150.
Further, in order to satisfactorily show the function (2), it is preferable to use as a material for the property improving layer 153 one whose HOMO level is between the HOMO level of the material for forming the light-emitting layers 150 and the HOMO level of the material for forming the hole injection layer 151, in the same organic EL element.

Furthermore, in order to satisfactorily show the function (3), as the material for the property improving layers 153, a metal ion trapping material which is optically and electrically inert may be used by replacing the materials represented by the compounds 5 to 7. The specific example of the above materials is crown ether having a function that supplements the metal ions. Particularly in the present embodiment, a 15-crown-5-ether represented by the following compound 8 is preferably used.

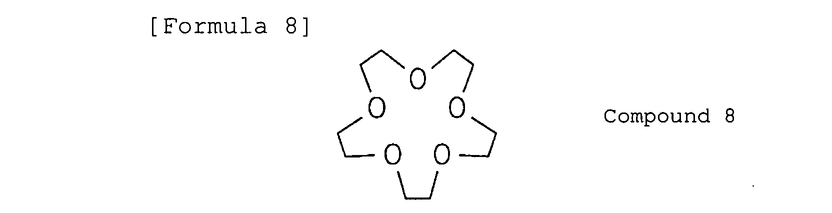

Crown ether itself such as 15-crown-5-ether may be used as a metal ion trapping material, and may also used as a compound forming a ring part (a skeleton part) in the metal ion trapping material. That is, like the following compound (9), oxygen atoms forming crown ether may be substituted with a nitrogen atom to have a structure containing the nitrogen atom to which is added a side chain such as an alkyl group.

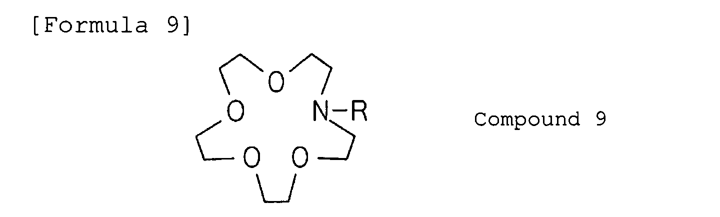

In a metal ion trapping material formed of the above-mentioned crown ether, particularly, since oxygen atom has negative charge, and thus it becomes easier to capture the metal ion (for example, Na ion) as ionic impurity carrying positive charge to form a complex.
Furthermore, since a selectivity of a metal ion to be captured depends on the size of crown ether ring, it is possible to select the crown ether ring of the size corresponding to an impurity (metal ion) to be expected, thereby obtaining a further improved capturing capability and an improved prevention of diffusion of the ionic impurity.

Furthermore, in order to satisfactorily show the function (3), as the material for the property improving layers 153, an inorganic ion exchangeable material may be used by replacing the materials represented by the compounds 5 to 7. As the inorganic ion exchangeable material, there are a type that absorbs the positive ion to supplementary fix it, a type that absorbs the negative ion to supplementary fix it, and a type that absorbs both the positive ion and the negative ion to supplementary fix them.
As the inorganic ion exchangeable material that supplementary fixes the positive ion, antimony pentoxide (Sb₂O₅) hydrate (for example, IXE-300 (registered trademark) made by TOAGOSEI CO., Ltd.) or titanium phosphate (for example, IXE-400 (registered trademark) made by TOAGOSEI co., Ltd.), or zirconium phosphate (for example, IXE-100 (registered trademark) made by TOAGOSEI co., Ltd.) may be used. Particularly, since the antimony pentoxide hydrate has a high absorption selectivity for Na ion, it is very suitable for the supplementary fixing the Na ion (ionic impurity) included as an impurity of the material for forming the hole injection layers 151.

As the inorganic ion exchangeable material that supplementary fixes the negative ion, hydrated bismuth oxide (for example, IXE-500 (registered trademark) made by TOAGOSEI CO., Ltd.) or hydrate lead phosphate (for example, IXE-1000 (registered trademark) made by TOAGOSEI co., Ltd.) may be used. Since the hydrated bismuth oxide has a high absorption selectivity for the sulfate ion (SO₄²⁻), it is very suitable for supplementary fixing the sulfate ion (ionic impurity) included in the material for forming the hole injection layers 151 as an impurity.

As the inorganic ion exchangeable material that absorbs both the positive and negative ions to supplementary fix, zirconium oxide, hydrated zirconium oxide, hydrated titanium oxide, bismuth, etc. (for example, IXE-600 (registered trademark) or IXE-633 (registered trademark) made by TOAGOSEI CO., Ltd.) may be used. If the above materials are used, it is possible to supplementary fix the Na ion included in the material for forming the hole injection layer and sulfate ion.

By using the above materials as a material for forming the property improving layers 153, it is possible to satisfactorily show the function (2). That is, since the property improving layers 153 that have a lower conductivity than the hole injection layers 151 and easily move to the hole injection layers 151 having a high conductivity are interposed between the light-emitting layers 150 and the hole injection layers 151, the mobility of the exciter which is located adjacent to the boundary of the hole injection layers 151 and the light-emitting layers 150 is controlled.

The counter electrodes (cathodes) 12 are provided on the light-emitting portions 110 (functional layers) over the entire surface of the EL element portion 11. Each of the counter electrodes (cathodes) 12, which constitute the pair together with each of the pixel electrodes 111, has a function of flowing a current to the light-emitting portion 110. Each of the counter electrodes is constructed with a laminated film (Ca/Al) of Ca and Al films. Here, for example, the Ca film has a thickness of about 20 nm, and the Al film has a thickness of about 200 nm.
In addition, the counter electrodes (cathodes) 12 may have different constructions for each of organic EL elements. For example, instead of Ca, calcium acetylacetatonate may be formed as a film in the organic EL elements emitting a red light component and the organic EL element emitting a blue light component. Since the calcium acetylacetatonate can be dissolved into an organic solvent, a liquid material made of calcium acetylacetatonate can be ejected by a liquid droplet ejection method to form the film.

In addition, an anti-oxidation protection layer 155 made of SiO, SiO₂, SiN, or the like, may be provided on the counter electrodes (cathodes) 12.
Next, the sealing substrate 604 is formed on the organic EL elements. The sealing substrate 604 is adhered with the sealing resin 603, as shown in Fig. 2(b). As a result, the organic EL device 1 is obtained.

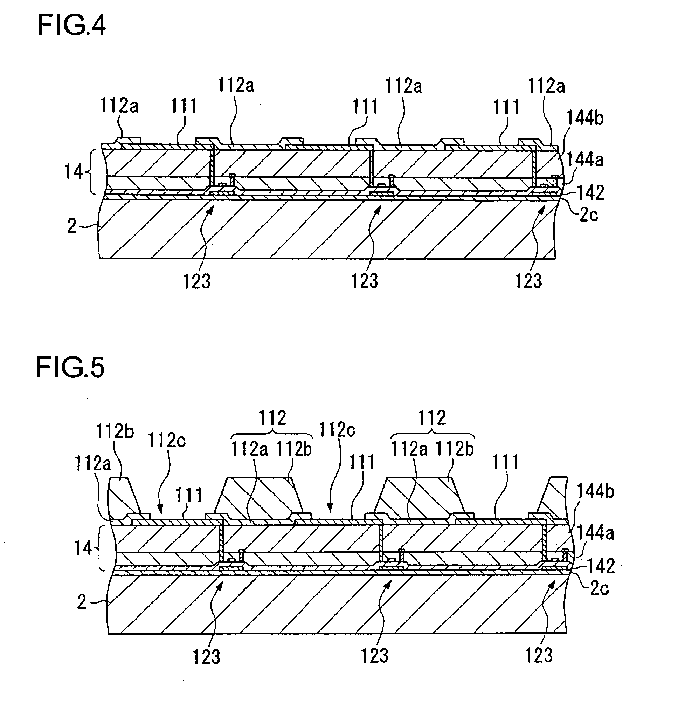

Now, a method of manufacturing a organic EL device according to the present invention will be described based on the method of manufacturing the organic EL device 1 having the aforementioned construction.
In order to manufacture the organic EL device 1, TFT elements (second thin film transistors 123) and various wiring lines are formed on the substrate 2 in the same manner as a conventional one as shown in Fig. 4. Next, interlayer insulating films or planarization films are formed.
Next, ITO are formed as a film on the substrate 2 by using a vapor deposition method and patterned, so that pixel electrodes 111 are formed.
Subsequently, inorganic banks 112a made of SiO₂ are formed on the substrate 2 so as to surround the periphery of the pixel electrodes 111. Next, as shown in Fig. 5, organic banks 112b made of a resin are formed on the inorganic banks 112a, so that openings 112c are formed on the pixel electrodes 111. Here, a polyimide or acryl resin may be used as a material for the organic banks 112b. A material containing fluorine in advance may be used as the material for the organic banks.

Next, the openings 112c surrounded by the inorganic banks 112a and the organic banks 112b are consecutively subjected to an oxygen plasma process and a CF₄ process, so that wettability of the surface of the substrate 2 can be controlled.
Next, a liquid material containing a material for forming the hole injection layers is selectively applied in the openings 112c by using the liquid droplet ejection method such as an inkjet method, so that the hole injection layers 151 (151R, 151G, 151B) are provided.

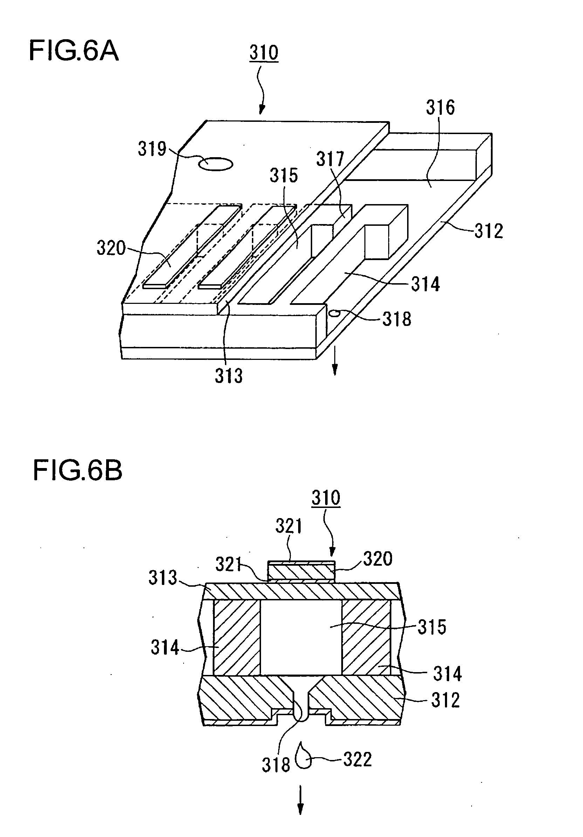

A liquid droplet ejection apparatus for ejecting liquid droplets by the liquid droplet ejection method preferably comprises a liquid droplet ejection head 310 shown in Fig. 6(a). The liquid droplet ejection head 310 comprises a nozzle plate 312 made of, for example, stainless steel and a vibrating plate 313, and are attached with partitioning members (reservoir plates) 314 therebetween. A plurality of spaces 315 and a liquid reservoir 316 are formed by the partitioning members 314 between the nozzle plate 312 and the vibrating plate 313. The spaces 314 and the liquid reservoir 316 are filled with a liquid material. The spaces 315 and the liquid reservoir 316 communicate with each other via supply inlets 317. In addition, a plurality of nozzle holes 318 for ejecting the liquid material from the spaces 315 is disposed in a row on the nozzle plate 312. In addition, a hole 319 for supplying the liquid material to the liquid reservoir 316 is provided on the vibrating plate 313.

In addition, a piezo-electric element (a piezo element) 320 is attached on the surface of the vibrating plate 313 opposite to the surface thereof facing the space 315, as shown in Fig. 6(b). The piezo-electric element 320 is disposed between a pair of electrodes 321. When turned on, the piezo-element is bent so as to protrude outwards. As a result, the vibrating plate 313 attached to the piezo-electric element 320 is integrated with the piezo-electric element 320 and also bent outwards, so that a volume of the space 315 can increase. Therefore, a liquid material corresponding to the increasing volume of the space 315 flows into the space from the liquid reservoir 316 via each of the supply lets 317. When the piezo-electric element 320 is turned off in this state, the piezo-electric element 320 and the vibrating plate 313 are restored to the original state. Since the space 315 is also restored to the original volume, the pressure of the liquid material in the space 315 increases, so that liquid droplets 322 can be ejected toward the substrate though the nozzle hole 318.
In addition, instead of the piezo-jet type using the aforementioned piezo-electric element 320, well-known types may be adapted to the liquid droplet ejection head 310.

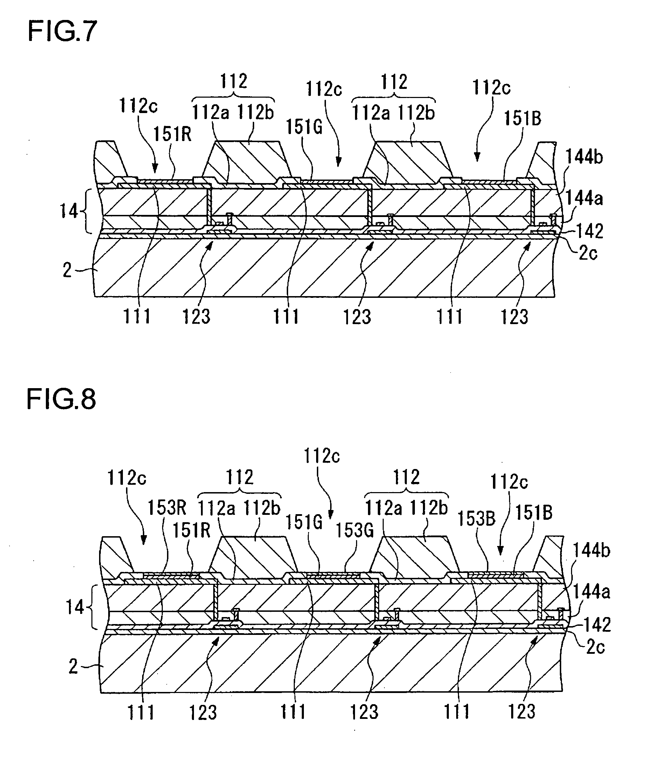

In the ejection of the liquid materials for the hole injection layers by using the liquid droplet ejection heads 310, the aforementioned liquid materials (liquid material made of PEDOT/PSS) are commonly ejected for every color organic EL element. Next, the ejected materials are subjected to a drying process and a sintering process, so that the hole injection layers 151 (151R, 151G, 151B) are formed on the pixel electrodes 111 as shown in Fig. 7. Here, during forming the hole injection layers 151R, 151G, 151B, the material (liquid material) for forming the hole injection layers need to be selectively ejected in the openings 112c. However, if the liquid droplet ejection method is adapted, it is possible to easily form the hole injection layers 150 by simply allocating the materials (liquid materials) for forming the hole injection layers to desired positions.

Next, the property improving layers 153 (153R, 153G, 153B) are formed on the hole injection layers 151 in the openings 112c. In the formation of the property improving layers 153R, 153G, 153B, the liquid droplet ejection method (inkjet method) using the aforementioned liquid droplet ejection heads 310 are also very suitably adapted. That is, in the formation of the property improving layer 153, any one of the liquid materials including the materials for forming the property improving layers 153 is ejected from the liquid droplet ejection heads 310 to the corresponding position. In this regard, the liquid materials enough to have thickness larger than the thickness of the property improving layer 153 to be actually formed are allocated.

Because allocating the excessive liquid materials, insolubilizing process is performed to the liquid material. As the insolubilizing process, a substrate 2 is mounted on a hot plate, and an annealing process is performed by heating the substrate about at 130°C to 180°C for 1 hour under inert atmosphere. Therefore, because the liquid materials are dried to be solidified and a cross-linking reaction is generated in the bottom, the bottom becomes insoluble.

Next, using xylene as a solvent used for forming the liquid materials, solid content having the liquid materials is re-dissolved. In this case, most of solid content is re-dissolved, but an insoluble portion in the bottom is not re-dissolved to be left. The left portion that is not re-dissolved and insoluble becomes the property improving layers 150. When the property improving layers 150 are formed so as to have the thickness of about 5 nm, the liquid materials are excessively allocated so as to make the film including the solid content after drying the liquid materials to have the thickness of about 60 nm.

The insolubilizing process is not limited to the annealing method by heating. The process may be performed by adding a photosensitive cross-liking initiator into the liquid material, drying, and irradiating light to cause the cross-liking reaction, which will eventually make a portion of the liquid material insoluble.
If one type of the property improving layers 153 is formed, the property improving layers 153 as shown in Fig. 8 are also formed by performing the same insolublizing process to the remaining two types by changing the liquid materials.

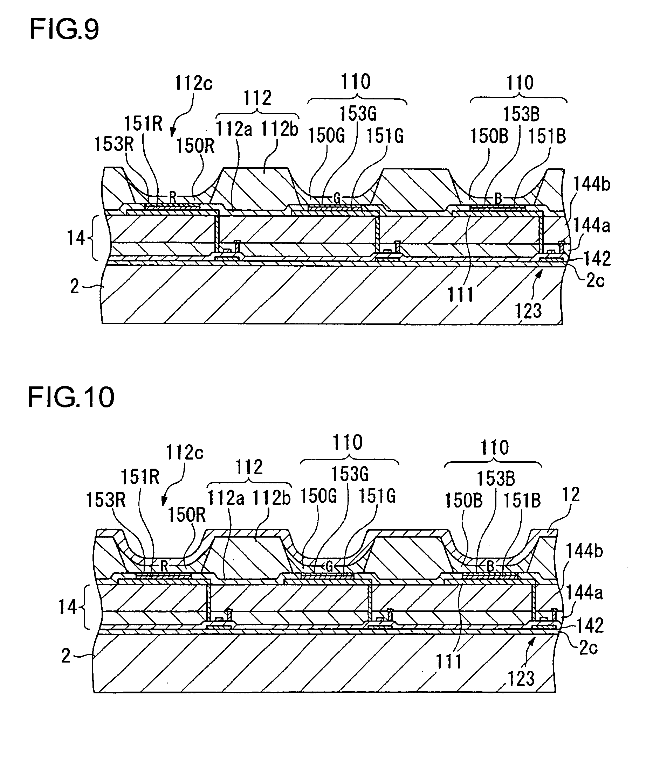

Next, the light-emitting layers 150 (150R, 150G, 150B) are formed on the property improving layers 153 in the openings 112c. In the formation of the light-emitting layers 150R, 150G, 150B, the liquid droplet ejection method (inkjet method) using the aforementioned liquid droplet ejection heads 310 are also very suitably adapted. That is, in the formation of the light-emitting layers 150R, 150G, and 150B, the aforementioned dedicated materials (materials corresponding to the colors) are ejected for the organic EL elements corresponding to the colors. Next, the materials are individually subjected to the drying process and the sintering process, so that light-emitting layers 150 (150R, 150G, 150B) are formed on the property improving layers 153 as shown in Fig. 9. In this regard, the light-emitting layers 150R, 150G, 150B need to be formed and allocated to the red, green, and blue, respectively. However, if the liquid droplet ejection method is adapted, it is possible to easily form the light-emitting layers by simply allocating the materials (liquid materials) for forming the light-emitting layers to desired positions.
Further, a solvent is included in the liquid materials for forming the light-emitting layers 150, and the property improving layers 153 are not insolubilized as mentioned above. As such, the property improving layers 153 are not re-dissolved by the solvent in the liquid materials.

After the light-emitting layers 150 (150R, 150G, 150B) are formed, and the light-emitting portion (functional layers) 110 are formed for the corresponding colors, the Ca films are formed to cover the light-emitting portions 110 and the organic banks. The Ca (calcium) films have a thickness of about 20 nm and are formed by using a vapor deposition method like the conventional method. Then, the Al (aluminum) films having a thickness of about 200 nm are formed. As a result, the counter electrodes (cathodes) 12 are formed in a laminated structure (Ca/Al), as shown in Fig. 10. Therefore, a plurality of organic EL elements, each of which comprises the pixel electrode (anode) 111, the light-emitting portion (functional layer) 110 and the counter electrode (cathode) 12, is formed.

In addition, with respect to the organic EL elements emitting a blue light component, the counter electrodes 12 are preferably formed in a laminated structure containing LiF. More specifically, the LiF films having a thickness of about 4 nm are selectively formed by using masks or the like with the vapor deposition method or the like. Next, the Ca films having a thickness of about 10 nm are formed, and then, the Al films having a thickness of about 20 nm are formed together with the organic EL element portions emitting different colors, so that the counter electrode (cathode) 12 are formed in a laminated structure of LiF/Ca/Al.
After the counter electrodes (cathodes) 12 are formed, the protection layer 155 and the sealing resin 603 are formed on the counter electrodes 12, and the sealing substrate 604 is adhered, so that the organic EL device 1 shown in Fig. 2 can be obtained.

In the resulting organic EL device, since the property improving layers 153 (153R, 153G, 153B) have a different structure for the emitting colors, the light-emitting layers 150 (150R, 150G, 150B) show optimal light-emitting characteristics. As a result, the display characteristics can be improved, so that it is possible to obtain an excellent display having the high quality and high brightness.

In addition, in the aforementioned manufacturing method, although the property improving layers 153 have different components for the three types of the organic EL elements emitting the red, green, and blue light components, the present invention is not limited thereto. The property improving layers 153 may be provided in one organic EL element and not in two remaining organic EL elements. Further, the property improving layers 153 may be provided in two organic EL elements and not in one remaining organic EL element.
Even when the property improving layers 153 are provided in three organic EL elements, the property improving layers 153 may have the same material for two organic EL elements, but may have a different material for the remaining organic EL element.

In addition, in the aforementioned manufacturing method, although the property improving layers 153 have different components for the three types of the organic EL elements emitting the red, green, and blue light components, in the present invention, the property improving layers may have suitably different components for the organic EL elements emitting the same color as described above.
As a result, for example, in a case where the light-emitting characteristics obtained at the locations of the organic EL elements in the organic EL device are different, if the property improving layers made of the optimum materials are constructed or not constructed so as to correspond to the required light-emitting characteristics, it is possible to obtain better light-emitting characteristics of the individual organic EL elements. Therefore, it is possible to improve the display characteristics.

Now, a specific example of an electronic apparatus comprising an organic EL device 1 having the aforementioned construction will be described.

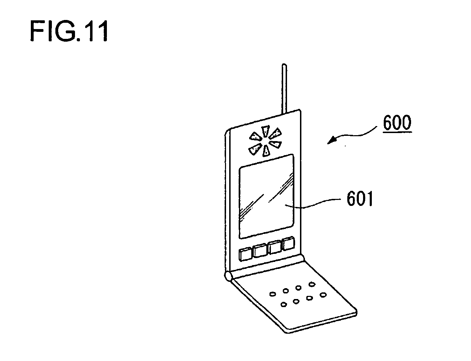

Fig. 11 is a perspective view showing an example of a cellular phone. In Fig. 11, reference numeral 600 indicates a main body of the cellular phone, and reference numeral 601 indicates a display portion using the organic EL device 1 described above.
Since the organic EL device 1 having improved display characteristics is used as the display unit of the electronic apparatus, the display characteristics of the display unit is sufficiently excellent.
In addition, the organic EL device according to the present invention may be suitably adapted to display units of various electronic apparatuses, for example, portable information processing apparatuses such as word processors and PCs, and wrist-watch type electronic apparatuses.

### [Reference Numerals]

1: DISPLAY (ELECTRO-OPTICAL DEVICE)
12: COUNTER ELECTRODE (CATHODE [ELECTRODE])
110: LIGHT-EMITTING PORTION (FUNCTIONAL LAYER)
111: PIXEL ELECTRODE (ANODE [ELECTRODE])
150 (150R, 150G, 150B): LIGHT-EMITTING LAYER
151 (151R, 151G, 151B): HOLE INJECTION LAYER
153 (153R, 153G, 153B): PROPERTY IMPROVING LAYER
600: MAIN BODY OF CELLULAR PHONE (ELECTRONIC APPARATUS)

## Claims

1. An organic EL device comprising a plurality of organic EL elements, each including a pair of electrodes and a functional layer between the electrodes, the functional layer including a hole injection layer and a light-emitting layer, wherein
one of the organic EL element has a property improving layer between the hole injection layer and the light-emitting layer, and
another of the organic EL element does not have a property improving layer between the hole injection layer and the light-emitting layer.

2. An organic EL device comprising a plurality of organic EL elements, each including a pair of electrodes and a functional layer between the electrodes, the functional layer including a hole injection layer and a light-emitting layer, wherein,
one of the organic EL element has a first property improving layer between the hole injection layer and the light-emitting layer, and
another of the organic EL element has a second property improving layer between the hole injection layer and the light-emitting layer of the other organic EL element, the second property improving layer has a different material from the first property improving layer.

3. The organic EL device according to Claim 1, wherein a color emitted from the light-emitting layer of the one organic EL element is different from colors emitted from the light-emitting layer of the other organic EL element.

4. The organic EL device according to any one of Claims 1 to 3,
wherein the thickness of the property improving layers is 1 to 10 nm.

5. The organic EL device according to any one of Claims 1 to 4, wherein the LUMO level of a material for forming the property improving layers is nearer to the vacuum level than the LUMO level of a material for forming the light-emitting layer in the same organic EL element.

6. The organic EL device according to any one of Claims 1 to 5, wherein the HOMO level of the material for forming the property improving layer is between the HOMO level of the material for forming the light-emitting layers and the HOMO level of the material for forming the hole injection layer, in the same organic EL element.

7. The organic EL device according to any one of Claims 1 to 6, further comprising organic EL elements for emitting a red light component, organic EL elements for emitting a green light component, and organic EL elements for emitting a blue light component.

8. A method of manufacturing an organic EL device comprising a plurality of organic EL elements, each including a pair of electrodes and a functional layer between the electrodes, the functional layer including a hole injection layer and a light-emitting layer, the method comprising the steps of:
forming a property improving layer between the hole injection layer and the light-emitting layer of one organic EL element among the organic EL elements, and
forming a property improving layer between the hole injection layer and the light-emitting layer of another organic EL element.

9. A method of manufacturing an organic EL device comprising a plurality of organic EL elements, each including a pair of electrodes and a functional layer between the electrodes, the functional layer including a hole injection layer and a light-emitting layer, the method comprising the steps of:
forming a first property improving layer between the hole injection layer and the light-emitting layer of one organic EL element among the organic EL elements, and
forming a second property improving layer between the hole injection layer and the light-emitting layer of another organic EL element.

10. The method of manufacturing the organic EL device according to Claim 8 or 9, wherein the light-emitting layer of the one organic EL element has a different material from that of the light-emitting layer of the other organic EL element.

11. The method according to any one of Claims 8 to 10, wherein the functional layer is formed by applying a liquid material containing a material for forming the functional layer using a liquid droplet ejection method.

12. The method according to Claim 11, wherein the property improving layers are formed by an insolubilizing process after applying the liquid material containing the material for the property improving layer by the liquid droplet ejecting method.

13. An electronic apparatus comprising an organic EL device according to any one of Claims 1 to 7 or an organic EL device manufactured by using the method according to any one of Claims 8 to 12.
